# EUROPEAN PATENT APPLICATION

(11) **EP 3 321 959 A1**
(43) Date of publication of application: **16.05.2018**
(21) Application number: 16198098.2
(22) Date of filing: 10.11.2016
(51) Int. Cl.: H01L 23/48, H01L 23/538, H02B 1/20, H05K 1/02, H01L 23/64

(54) **POWER SEMICONDUCTOR MODULE**

(71) Applicant: ABB Schweiz AG, 5400 Baden (CH)
(72) Inventor: Hartmann, Samuel, 5603 Staufen (CH)
(74) Representative: ABB Patent Attorneys

(57) **Abstract**

The present invention relates to a power semiconductor module, comprising an electronic circuit having a printed circuit board (10) with a substrate (12), the substrate (12) comprising a first side (36) and a second side (38), the second side (38) being arranged opposite to the first side (36) and being arranged parallel to the first side (36), wherein a first conductor (14) being designed as a gate conductor and a second conductor (16) being designed as an auxiliary emitter conductor are positioned on the printed circuit board (10), wherein the first conductor (14) proceeds partly on the first side (36) and partly on the second side (38) and that the second conductor (16) proceeds partly on the first side (36) and partly on the second side (38), such, that the first conductor (14) and the second conductor (16) are at least partly arranged opposite to each other and that the first conductor (14) proceeds on the first side (36) in a rage of ≥ 10% to ≤ 90% of its total extension on the first side (36) and the second side (38) and that the second conductor (16) proceeds on the first side (36) in a range of ≥10% to ≤ 90% of its total extension on the first side (36) and the second side (38).

## Description

### Technical Field

The present invention relates to a power semiconductor module. The present invention particularly refers to a power semiconductor module showing an improved and especially defined switching behaviour.

### Background Art

Power semiconductor modules comprising power semiconductor devices are generally known in the art. It is generally known to use power semiconductor devices being designed as switching devices.

The switching speed of such devices, such as of IGBT modules, is influenced by voltage induced in the control circuit. This can make a module faster or slower switching.

DE 295 21 240 U1 describes a control circuit comprising an IGBT or a MOSFET. Such a control circuit should address the problem of suppressing the influence of magnetic flux from the power circuit on a control circuit. The control circuit is formed symmetric with respect to parts of the power circuit perpendicular to the control circuit and far away from parts parallel to the power circuit.

JP 2005093756 describes a semiconductor module having a semiconductor switching element. In order to prevent a damage of the semiconductor switching elements, this document proposes to provide a parallel current flow of the control wiring, i.e. the gate, and the control cathode wiring to reduce electromagnetic effects.

JP 2015149842 A describes a power semiconductor module. In order to inhibit imbalance of influence of floating inductance between a gate terminal and an emitter terminal and electromagnetic noise from a bus bar for supplying power, it is proposed that the power semiconductor module comprises an upper arm circuit part having an upper arm power semiconductor element, a positive terminal, an AC terminal, an upper arm gate terminal and an upper arm emitter terminal; and a lower arm circuit part having a lower arm power semiconductor element, a negative terminal, an AC terminal, a lower arm gate terminal and a lower arm emitter terminal. The positive terminal, the upper arm gate terminal and the upper arm emitter terminal projects in the same direction. The negative terminal, the lower arm gate terminal and the lower arm emitter terminal project in the same direction. The upper arm emitter terminal is arranged closer to the positive terminal than the upper arm gate terminal. And the lower arm gate terminal is arranged closer to the negative terminal than the lower arm emitter terminal.

JP 2002184939 describes a power module which can be used in the power conversion of the inverter or the like. This module is described to be capable of preventing malfunction of the control circuit. The power module therefore comprises an insulating board and a control board provided in a housing. The module further comprises a main circuit wiring of the insulating board for generating no induction current in a GND loop of the control board by a magnetic field generated by the current flowing to the wiring.

JP 201148458 A describes a power semiconductor module which should operate stably. Therefore, the power semiconductor module is described to comprise a structure in which a member containing a power semiconductor element is arranged on an insulating board, a control board mounted with a control circuit for this member is arranged above the insulating board, and the signal terminal of the member and the control circuit of the member are connected with at least a pair of signal wires, where a pair of relay terminals provided between a relay board provided on the insulating board and the control board are made to serve as a part of the signal wires, the relay terminals cross each other at least at a point, when they are projected on a certain plane, and they approach each other at this intersection.

JP 2009021345 A describes a power semiconductor module which is described to have a low electric power loss or high destructive strength. Therefore, the power semiconductor module has the main electrode terminal to which the collector-emitter current of the power semiconductor element flows and a wiring circuit board which performs electric control over the power semiconductor element and is disposed nearby the main electrode terminal. The wiring circuit board has an emitter pattern connected to the emitter of the power semiconductor element and a gate pattern connected to the gate of the power semiconductor element, the gate pattern having an induction causing pattern extending in parallel to a direction where the current of the main electrode terminal flows while not shielded by the emitter pattern.

The before-named solutions, however, still give room for improvements, especially regarding lowering negative magnetic effects on the switching performance.

### Disclosure of Invention

It is an object of the present invention to provide a power semiconductor module which overcomes at least one drawback of the prior art. It is especially an object of the present invention to provide a power semiconductor module which reduces an undesired magnetic impact and may thus improve the switching behaviour of a power semiconductor device.

These objects are at least partly solved by a power semiconductor module according to independent claim 1. Advantageous embodiments of the present invention are given in the dependent claims, in the further description as well as in the figures, wherein different embodiments can, alone or in any combination, provide a feature of the present invention unless not clearly excluded.

The present invention provides a power semiconductor module, comprising an electronic circuit having a printed circuit board with a substrate, the substrate comprising a first side and a second side, the second side being arranged opposite to the first side and being arranged parallel to the first side, wherein a first conductor being designed as a gate conductor and a second conductor being designed as an auxiliary emitter conductor are positioned on the printed circuit board. It is provided that the first conductor proceeds partly on the first side and partly on the second side and that the second conductor proceeds partly on the first side and partly on the second side, such, that the first conductor and the second conductor are at least partly arranged opposite to each other and that the first conductor proceeds on the first side in a range of ≥ 10% to ≤ 90 % of its total extension on the first side and the second side and that the second conductor proceeds on the first side in a range of ≥10% to ≤ 90% of its total extension on the first side and the second side.

Having a constant width of the conductors, the extension may thus be chosen by the respective length of the conductors.

Such a power semiconductor module provides a decreased undesired magnetic influence and thus an improved switching behaviour.

The power semiconductor module as described above thus comprises an electronic circuit. The electronic circuit may particularly comprise a gate circuit which comprises a gate connection and an auxiliary emitter connection. In order to provide such an electric circuit, a printed circuit board (PCB) is provided.

The printed circuit board comprises a substrate with a first side and a second side, the second side being arranged opposite to the first side and being arranged parallel to the first side. In other words, the substrate may be formed plate-like and has a first side and opposite to the first side a second side.

Especially as a part of the electric circuit, a first conductor is provided which is designed as a gate conductor and a second conductor is provided which is designed as an auxiliary emitter conductor. As such, the first and the second conductor may form part of a gate circuit as it is generally known in the art. The first conductor as well as the second conductor are positioned on the printed circuit board and proceed in a first direction. This shall particularly mean that the first and the second conductor may have a direction in which current flows through the respective conductor, especially from one connector to a further connector. This direction may be the length of the conductor.

With regard to the conductors, it may particularly be provided that the first and the second conductor may be formed as electrically conductive coatings on the substrate of printed circuit board, such as a metallization.

With regard to the first conductor, it is provided that the latter proceeds partly on the first side and partly on the second side. Correspondingly and with regard to the second conductor, it is provided that the latter proceeds partly on the first side and partly on the second side. Therefore, it is provided that both the first and the second conductor proceed both on the first and the second side. It is particularly provided that the first conductor and the second conductor are arranged at least partly opposite to each other and thus, at an area at which the first conductor proceeds at the first side, the second conductor proceeds at the second side, and vice versa. Thus, it may be provided at least partly that in case a first or second conductor is provided at the first side, at the corresponding opposite position there is provided a second conductor, and vice versa.

In other words, the printed circuit board has one or more first regions in which the first conductor is on the first side and the second conductor is on the second side, whereas in one or more second regions the first conductor is provided on the second side and the second conductor is provided on the first side. With this regard it may be provided that equal or more than 70%, preferably equal or more than 80%, for example equal or more than 90%, of the first conductor, or its extension, respectively, is located opposite to the second conductor and that equal or more than 70%, preferably equal or more than 80%, for example equal or more than 90%, of the second conductor, or its extension, respectively, is located opposite to the first conductor.

With this regard, like indicated before, the gate conductor may follow the emitter conductor in parallel.

With regard to the relation in which the first and the second conductor proceeds at the first and the second side, respectively, it is provided that
the first conductor proceeds on the first side at least 10% of its total extension on the first side and the second side and that the second conductor proceeds on the first side at least 10% of its total extension on the first side and the second side.

Therefore, both the first and the second conductor proceed in an amount of ≥ 10% to ≤ 90% of their total extension on the first side and on the second side. Or in other words, the one or more first regions comprise ≥ 10% to ≤ 90% of the sum of the first and the second regions, and the one or more second regions comprise ≥ 10% to ≤ 90% of the sum of the first and second regions, the first and second regions being defined as above.

An arrangement as described before provides significant advantages over the prior art solutions.

In detail, the before-described solution takes advantage of the possibility to implement the control circuit for a power module by having a printed circuit board with a two layer structure carrying the auxiliary emitter and gate conductor tracks. It was utilized that the design of the printed circuit board as well as the conductors being located thereon play an important role for the module to achieve good switching performance under normal switching conditions and under short circuit conditions.

In fact, the area between the first and the second conductor, and thus the auxiliary emitter and the gate conductor tracks, in case they are provided one on the first side and the other on the second side, is susceptible for magnetic field components which are in plane of the printed circuit board and normal to the conductor tracks. In other words, a magnetic field may be provided in the plane of the substrate of the printed circuit board. The magnetic field in turn may induce a voltage into the control circuit. The resulting disturbance of the gate voltage might speed up or slow down the power module. It might for example be the case that the module is switching too slowly due to this electromagnetic coupling. An option would then be to flip the two conductor layers of the printed circuit board as this measure may change the sign of the disturbance. The switching speed is than increased instead of lowered. However, with this regard it may further be the case that the power module will then switch too fast.

However, none of the two before-described extreme positions is the desired state.

According to a power module as described before, it becomes possible to achieve none of the before-described extreme situations, but to realize a coupling behavior which is in between of these two extremes, which in fact may be a desired feature.

In detail, due to the fact that the coupling behavior and in turn the switching behavior of a power module may be adapted simply by changing the amount at which the first conductor and the second conductor proceeds on the first side and the second side, respectively, it becomes clear that a very effective adjustment to the desired needs can be achieved. This may simply be realized by choosing the design of the conductors, which is practicable without problems and particularly without significant extra effort and costs when producing the power module.

Therefore, a power module as described before allows adapting and securing the switching behavior to the desired need in a very easy and effective manner.

Taking into consideration the above it becomes clear that it is most preferred that the power semiconductor module comprises a power semiconductor device which is designed as a switching device. Examples for such switching devices may in a non-limiting manner be selected from the group consisting of an IGBT, a MOSFET and the like.

Generally, it may be provided that the power module as described before comprises a plurality of power semiconductor devices and may thus be called a multi-chip power semiconductor module. Further, it may particularly provided that the power semiconductor module is designed in a half-bridge configuration.

The power semiconductor module may particularly be designed in a half-bridge configuration. With this regard, it may be preferred that the main DC+ and DC- terminals are located on one side of the module and that the AC terminal plate is located at an opposite side of the module. Outer auxiliary emitter and gate terminals are near the AC terminals and the control PCB is located on top of AC terminal plate. It may further be provided that the connection from the printed circuit board 10 to the power substrate (DCB / AMB) is made in the center of the module. For the control circuit of the high side switch, the gate conductors in the first region may be on the top layer of the printed circuit board. In other words, it may be provided that that more than 50% of the extension of the first conductor, or gate, respectively, are on the first side and that more than 50% of the second conductor, or auxiliary emitter, are on the second side. This may allow an especially effective damping in case of a short circuit.

According to an embodiment, it may be provided that the first conductor proceeding on the first side and the first conductor proceeding on the second side are connected by a via structure, and that the second conductor proceeding on the first side and the second conductor proceeding on the second side are connected by a via structure. With this regard, a via structure may provide a very effective electric connection of the respective conductors on the first side and on the second side, the electric connection having especially low losses. In other words, an electric connection may be provided which has a low ohmic resistance. This may ensure providing a power module having a very effective working behaviour.

Apart from that, it may in an embodiment be prevented that an electrical connection proceeds around the substrate of the printed circuit board which may in that case may have an influence to the switching behavior and/or which may be comparably complex to produce, or to implement in a power module, respectively.

With regard to the via structure provided for connecting the respective conductors on the first side and the second side, respectively, it may be provided that the via structure comprises at least four vias which are alternately used for connecting the first conductor proceeding on the first side and the second side and for connecting the second conductor proceeding on the first side and the second side. It may be especially preferred that the via structure comprises the vias such, that they are arranged in a direction perpendicular to the direction the conductors are proceeding in and thus the current is flowing.

Especially such a via structure having four alternating vias may provide significant advantages with regard to the electronic properties of the power module. In particular, it may be provided that advantages with regard to the self-inductance may be reached insofar it is comparably low, which in turn may improve the switching behaviour of the power module.

According to a further embodiment, it may be provided that the first conductor proceeds on the first side in a range of ≥ 30% to ≤ 70% of its total extension on the first side and the second side and that the second conductor proceeds on the first side in a range of ≥ 30% to ≤ 70% of its total extension on the first side and the second side. This embodiment allows an especially effective adjustment of the coupling and thus of the switching behaviour like described before. However, it has to be noted that the specific values are dependent from the desired need.

According to a further embodiment, it may be provided that the printed circuit board has a substrate on which the first conductor and the second conductor are provided, wherein the substrate has a thickness, proceeding from the first side to the second side, in a range of ≥ 1 mm. It may particularly be provided that the substrate has a thickness, proceeding from the first side to the second side, in a range of ≥ 1 mm to ≤ 2,5mm.This embodiment allows an especially stable substrate and thus an especially stable printed circuit board. Especially, it may be provided that the conductive structures and further respective connections, such as wire bonds, or terminals can be provided without negatively influencing the stability of the whole structure.

According to a further embodiment, it may be provided that at least one of the first conductor and the second conductor has a thickness of ≥ 20 µm. Preferably, it may be provided that both the first and the second conductor have thickness in the before defined range. Especially, the whole structure of the conductor which is provided on the substrate of the printed circuit board may lie in the before-defined range. With regard to this range, it may be advantageous that the first and/or second conductor has at least partly preferably fully, a thickness in the range of ≥ 20 µm to ≤ 120µm. This embodiment allows an electrical conduction with an especially low ohmic resistance. Therefore, the power module may work especially effectively and with low losses.

The same advantage may be provided in case at least one of the first conductor and the second conductor has a width of ≥ 2 mm. Preferably, it may be provided that both the first and the second conductor have a width in the before defined range. Especially, the whole structure of the conductor which is provided on the substrate of the printed circuit board may have a thickness in the before-defined range. With regard to this range, it may be advantageous that the first and/or second conductor has at least partly preferably fully, a width in the range of ≥ 2mm to ≤ 10mm. Again, this embodiment allows an electrical conduction with an especially low ohmic resistance. Therefore, the power module may work especially effectively and with low losses. Apart from that, this embodiment allows a reduced self-inductance which has significant advantages with regard to the switching behaviour.

According to a further embodiment, it may be provided that at at least one of the first conductor and the second conductor is formed from copper, for example covered with nickel, nickel/gold or tin. It may be especially preferred that both the first and the second conductor are formed from such a material. This embodiment may allow a conductance with an especially low ohmic resistance thus allowing an especially effective working behaviour of the power module.

With regard to further advantages or features of the power semiconductor module, it is referred to the figures as well as to the description of the figures.

### Brief Description of Drawings

These and other aspects of the invention will be apparent from and elucidated with reference to the embodiments described hereinafter.

In the drawings:
Fig. 1 shows a schematic view of a part of a power semiconductor module from slanted above; and
Fig. 2 shows a schematic view of the part of Fig. 1 from slanted below; and
Fig. 3 shows a detailed view of a via structure of the part of Fig. 1.

### Detailed Description of the Invention

Reference will now be made in detail to an exemplary embodiment, which is illustrated in the figures. This example is provided by way of explanation and is not meant as a limitation. It is intended that the present disclosure includes further modifications and variations.

Within the following description of the drawings, the same reference numbers refer to the same components. Generally, only the differences with respect to the individual embodiments are described. When several identical items or parts appear in a figure, not all of the parts have reference numerals in order to simplify the appearance.

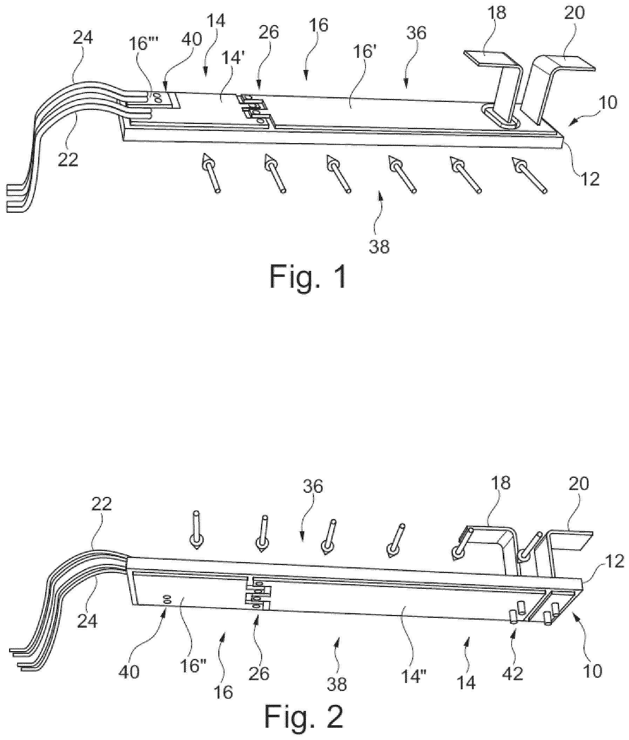

Figures 1 and 2 shows a view of a part of a power semiconductor module.

In particular, a control circuit as an electronic circuit is shown having a printed circuit board 10 with a substrate 12 having a first side 36 and a second side 38, the second side 38 being arranged opposite to the first side 36 and being arranged parallel to the first side 36. A first conductor 14 is provided which is designed as a gate conductor and a second conductor 16 is provided being designed as an auxiliary emitter conductor, wherein the first conductor 14 and the second conductor 16 are positioned on the printed circuit board 10, or its substrate 12, respectively.

The first conductor 14 and the second conductor 16 may be formed from copper.

It is further provided that the first conductor 14 proceeds partly on the first side 36 and partly on the second side 38 and the second conductor proceeds partly on the first side 36 and partly on the second side 38 such, that the first conductor 14 and the second conductor 16 are arranged at least partly opposite to each other, wherein the first conductor 14 proceeds on the first side 36 in a range of ≥ 10% to ≤ 90% of its total extension on the first side 36 and the second side 38 and that the second conductor 16 proceeds on the first side 36 in a range of ≥ 10% to ≤ 90% of its total extension on the first side 36 and the second side 38.

In particular, it may be provided that the first conductor 14 proceeds on the first side 36 in a range of ≥ 30% to ≤ 70% of its total extension on the first side 36 and the second side 38 and that the second conductor 16 proceeds on the first side 36 in a range of ≥ 30% to ≤ 70 % of its total extension on the first side 36 and the second side 38.

It can thus be seen that both the first conductor 14 and the second conductor 16 comprise a part 14', 16' that proceeds on the first side 36 and a further part 14", 16" that proceeds on the second side 38.

In order to achieve this, the part 14' of the first conductor 14, which proceeds on the first side 36 and the corresponding part 14" of the first conductor 14 that proceeds on the second side 38 are connected by a via structure 26. Correspondingly, the part 16' of the second conductor 16, which proceeds on the first side 36 and the corresponding part 16" of the second conductor 16 that proceeds on the second side 38 are connected by the via structure 26.

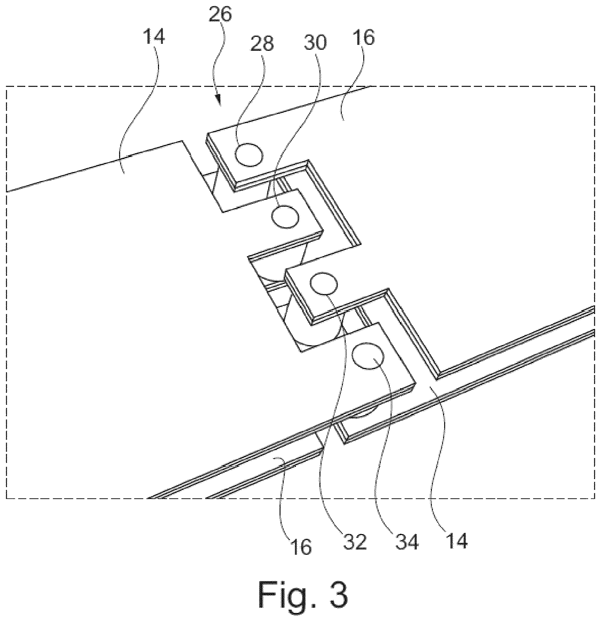

The via structure 26 is shown in figure 3. In detail four vias 28, 30, 32, 34 are provided which are alternately used for connecting the first conductor 14 proceeding on the first side 36 and the second side 38, or the respective parts 14', 14" thereof, respectively, and for connecting the second conductor 16 proceeding on the first side 36 and the second side 38, or the respective parts 16', 16" thereof, respectively. In detail, the vias 28, 32 belong to the second conductor 16 and the vias 30, 34 belong to the first conductor 14.

It is further shown in figures 1 and 2 that the first conductor 14 is connected on the one side with bond wires 22 and on the further side with a terminal 18, and, correspondingly, that the second conductor 16 is connected on the one side with bond wires 24 and on the further side with a terminal 20. The terminals 18, 20 or terminal plates, respectively, make the connection to the module outside and the bond wires 22, 24 make the connection to the power substrates.

In order to achieve this, the part 16"' of the second conductor 16 may be provided on the first side 36 and may be contacted to the part 16" by a further via structure 40. Further as the terminal 18 and the terminal 22 may be provided both on the same side, such as on the first side 36, the terminal 18 may be insulated from the second conductor 16 on the first side and may be connected to the first connector 14 on the second side by an electrically conductive connection 42 in case the terminal18 is located within a second conductor 16. However, the inverse structure may as well be realized without leaving the present invention.

It is preferably provided that the printed circuit board 10 has the substrate 12 on which the first conductor 14 and the second conductor 16 are provided, wherein the substrate 12 has a thickness, proceeding from the first 36 side to the second side 38, in a range of ≥ 1mm.

Further, it is advantageous that at least one of the first conductor 14 and the second conductor 16 has a thickness of ≥ 20 µm, and/or that at least one of the first conductor 14 and the second conductor 16 has a width of ≥ 2 mm, wherein the length and/or the width may be preferably be provided in case the first conductor 14 and/or the second conductor 16 is an electrically conductive coating on the substrate 12.

The arrows shown in figures 1 and 2 should show the magnetic field.

Such a power module may provide fine tuned module switching characteristics without additional costs, In detail, the control circuit print shown in Figure 1 and Figure 2 will switch quite fast since the indicated magnetic field will induce additional voltage in the control circuit during turn-on of the IGBT. According to the embodiment shown, for about 2/3 of the conductor length, the layers are flipped and thus gate and auxiliary emitter layer flipped in only a part of the PCB area. As a result a strong accelerating coupling will be changed into a moderately damping coupling.

The power semiconductor module may particularly be designed in a half-bridge configuration. With this regard, it may be preferred that the main DC+ and DC- terminals are located on one side of the module and that the AC terminal plate is located at an opposite side of the module. Outer auxiliary emitter and gate terminals 18, 20 are near the AC terminals and the control PCB is located on top of AC terminal plate. It may further be provided that the connection from the printed circuit board 10 to the power substrate (DCB / AMB) is made in the center of the module. For the control circuit of the high side switch, the gate conductors in the first region may be on the top layer of the printed circuit board. In other words, it may be provided that that more than 50% of the extension of the first conductor, or gate, respectively, are on the first side 36 and that more than 50% of the second conductor, or auxiliary emitter, are on the second side 38. This may allow an especially effective damping in case of a short circuit.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 10: printed circuit board
- 12: substrate
- 14: first conductor
- 14': part of first conductor
- 14": part of first conductor
- 16: second conductor
- 16': part of second conductor
- 16": part of second conductor
- 16"': part of second conductor
- 18: terminal
- 20: terminal
- 22: wire bond
- 24: wire bond
- 26: via structure
- 28: via
- 30: via
- 32: via
- 34: via
- 36: first side
- 38: second side
- 40: via structure
- 42: connection

## Claims

1. Power semiconductor module, comprising an electronic circuit having a printed circuit board (10) with a substrate (12), the substrate (12) comprising a first side (36) and a second side (38), the second side (38) being arranged opposite to the first side (36) and being arranged parallel to the first side (36), wherein a first conductor (14) being designed as a gate conductor and a second conductor (16) being designed as an auxiliary emitter conductor are positioned on the printed circuit board (10), **characterized in that** the first conductor (14) proceeds partly on the first side (36) and partly on the second side (38) and that the second conductor (16) proceeds partly on the first side (36) and partly on the second side (38), such, that the first conductor (14) and the second conductor (16) are at least partly arranged opposite to each other and that the first conductor (14) proceeds on the first side (36) in a range of ≥ 10% to ≤ 90% of its total extension on the first side (36) and the second side (38) and that the second conductor (16) proceeds on the first side (36) in a range of ≥ 10% to ≤ 90% of its total extension on the first side (36) and the second side (38).

2. Power semiconductor module according to claim 1, **characterized in that** the first conductor (14) proceeding on the first side (36) and the first conductor (14) proceeding on the second side (38) are connected by a via structure (26), and **in that** the second conductor (16) proceeding on the first side (36) and the second conductor (16) proceeding on the second side (38) are connected by a via structure (26).

3. Power semiconductor module according to claim 2, **characterized in that** the via structure (26) comprises at least four vias (28, 30, 32, 34) which are alternately used for connecting the first conductor (14) proceeding on the first side (36) and the second side (38) and for connecting the second conductor (16) proceeding on the first side (36) and the second side (38).

4. Power semiconductor module according to any of the preceding claims, **characterized in that** equal or more than 70%, preferably equal or more than 80%, for example equal or more than 90%, of the first conductor (14) is located opposite to the second conductor (16) and that equal or more than 70%, preferably equal or more than 80%, for example equal or more than 90%, of the second conductor (16) is located opposite to the first conductor (14).

5. Power semiconductor module according to any of the preceding claims, **characterized in that** the substrate (12) of the printed circuit board (10) has a thickness, proceeding from the first side (36) to the second side (38), in a range of ≥ 1 mm.

6. Power semiconductor module according to any of the preceding claims, **characterized in that** at least one of the first conductor (14) and the second conductor (16) has a thickness of ≥ 20 µm.

7. Power semiconductor module according to any of the preceding claims, **characterized in that** at least one of the first conductor (14) and the second conductor (16) has a width of ≥ 2 mm.

8. Power semiconductor module according to any of the preceding claims, **characterized in that** at least one of the first conductor (14) and the second conductor (16) is formed from copper.

9. Power semiconductor module according to any of the preceding claims, **characterized in that** the power semiconductor module comprises a power semiconductor device being designed as a switching device, in particular being selected from the group consisting of an IGBT, a MOSFET.

10. Power semiconductor module according to any of the preceding claims, **characterized in that** the power semiconductor module is designed as a half bridge module.
